(19) **Europäisches Patentamt / European Patent Office / Office européen des brevets**

(11) **EP 3 205 498 A1**

(12) # EUROPEAN PATENT APPLICATION
published in accordance with Art. 153(4) EPC

(43) Date of publication:
**16.08.2017 Bulletin 2017/33**

(21) Application number: **15849092.0**

(22) Date of filing: **06.10.2015**

(51) Int Cl.:
**B32B 27/32** (2006.01)  **C08F 210/16** (2006.01)
**C08J 5/18** (2006.01)  **B65D 65/40** (2006.01)

(86) International application number:
**PCT/JP2015/078260**

(87) International publication number:
**WO 2016/056524 (14.04.2016 Gazette 2016/15)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **07.10.2014 JP 2014206232**

(71) Applicant: **Prime Polymer Co., Ltd.**
**Tokyo 105-7117 (JP)**

(72) Inventors:
• **YANAGISHITA, Yoshio**
**Ichihara-shi**
**Chiba 299-0108 (JP)**

• **TAGUCHI, Eiichi**
**Koga-shi**
**Ibaraki 306-0213 (JP)**
• **MARUYAMA, Kazuhide**
**Koga-shi**
**Ibaraki 306-0213 (JP)**
• **NAMIKI, Akio**
**Koga-shi**
**Ibaraki 306-0213 (JP)**

(74) Representative: **J A Kemp**
**14 South Square**
**Gray's Inn**
**London WC1R 5JJ (GB)**

(54) **FILM FOR DEPOSITION OF INORGANIC SUBSTANCE, INORGANIC SUBSTANCE DEPOSITED FILM, AND USE THEREOF**

(57) [Problem] To provide a film for inorganic substance deposition, which does not lower adhesion properties of an inorganic substance deposit surface during dry lamination even after an inorganic substance deposit layer is formed on the film and the film is stored in a rolled state for a long period of time.

[Solution] A film for inorganic substance deposition is a film for inorganic substance deposition, comprising single or multiple resin layers, wherein all of the resin layers contain an ethylene-based polymer (A) having a melt tension (MT), as measured at 190 °C, of not more than 5.0 g, and the film satisfies the following requirements (1) to (3) ; requirement (1) : the amount of a component generated by heating the film under the prescribed conditions is not more than 1.2 $\mu$g per milligram of the film, requirement (2): the amount of a compound containing pentavalent phosphorus, said compound being recovered after washing of a surface of the film under the prescribed conditions, is not more than 9 $\mu$g, and requirement (3): the amount of an oxide of an oligomer of a hexamer to a decamer, said oxide being recovered after washing of a surface of the film under the prescribed conditions, is not more than 1.5 $\mu$g.

**Description**

Technical Field

Thepresent invention relates to a filmpreferable for depositing an inorganic substance thereon, a deposited film obtained by depositing an inorganic substance on the film and uses of the deposited film.

Background Art

Deposited films obtained by vacuum depositing inorganic substances, e.g., metals such as aluminum, and alumina oxide, on one side surfaces of films of various resins such as polypropylene, polyethylene and polyester are excellent in water vapor or gas barrier properties, have aroma retention properties and light blocking properties and have a decorative effect.

When such a deposited film is bonded to another film by carrying out dry lamination for bonding the deposited film and another film with an adhesive or is bonded to another film by the use of a molten resin and when the composition of the deposited film has poor adhesion to the molten resin, adhesive surfaces of this deposited film and another film are coated with an anchor coating agent (anchoring agent) in advance to enable them to adhere to each other, and thereafter, extrusion lamination is carried out, whereby the deposited film is utilized mainly as a laminated film (laminated film).

In claim 1 of Japanese Patent Laid-Open Publication No. 1995-166328 (patent literaturel), a deposited film obtained by forming a thin film of a metal or a metal oxide on a film of an ethylene/$\alpha$-olefin copolymer obtained by polymerization using a single-site catalyst is described. In the paragraph [0020] of the patent literature 1, it is described that examples of polymerization methods to obtain the ethylene/$\alpha$-olefin copolymer include bulk polymerization, solution polymerization, suspension polymerization and vapor phase polymerization. Further, in the working examples, it is described that "an ethylene/1-hexene copolymer (d: 0.920g/cm$^3$, [MI] : 4) obtained by polymerization using a single-site catalyst (Kaminsky catalyst: catalyst of a combination of zirconocene dichloride and methylalumoxane (molar ratio 1:1250)" was used. However, specific polymerization methods (polymerization conditions) are not described.

In the working examples of Japanese Patent Laid-Open Publication No. 1983-19309 (patent literature 2), one of the inventors of which is Kaminsky, who is described in the working examples of the patent literature 1, it is described that solution polymerization was carried out at a polymerization of 20 to 90°C using a toluene solvent to obtain an ethylene homopolymer or an ethylene/1-hexane copolymer.

In the section of performance evaluation in the patent literature 1, it is described that a laminated film obtained by dry laminating a biaxially oriented polyester film onto a deposit surface of a deposited film obtained in the working examples is excellent in laminating strength.

In claim 1 of Japanese Patent Laid-Open Publication No. 1997-193324 (patent literature 3), "a film for metal deposition obtained by using a copolymer which is obtained by polymerization of ethylene and an $\alpha$-olefin of 3 to 20 carbon atoms using a metallocene catalyst and has specific properties" is described. In the paragraph [0013] of the patent literature 3, there are descriptions: "Examples of methods for copolymerizing ethylene and an $\alpha$-olefin include vapor phase method, slurry method, solution method and high pressure method, but in the solution method, polymerization is carried out in the presence of a large amount of a solvent, and therefore, the solvent remains in a large amount in the polymer, so that this method is undesirable. On the other hand, in the high pressure method, polymerization is carried out in a state of an extremely high monomer concentration, and therefore, polymerization activity can be greatly increased, and the residues of a solvent and a low-molecular weight component can be significantly reduced. Also in the vapor phase method, polymerization is carried out in the absence of a solvent, and therefore, no solvent remains in the polymer." In the working examples of the patent literature 3, further, there is a description: "An ethylene/1-hexene copolymer (density: 0.922g/cm$^3$, MFR: 3.4g/10min, Mw/Mn: 1.9, ratio of mean number of branches : 1.1) was used. " However, specific polymerization methods (polymerization conditions) are not described.

In Japanese Patent No. 4346004 (patent literature 4), there is described a method in which when an aluminum deposited film using LLDPE obtained by polymerization using a metallocene catalyst and a carrier layer such as paper are laminated with each other, they are laminated by extrusion lamination using molten polyethylene between the aluminum deposit surface and the carrier layer. Further, it is described that by extrusion lamination using LDPE or the like, a laminate having excellent adhesive strength is obtained.

Citation List

Patent Literature

Patent literature 1: Japanese Patent Laid-Open Publication No. 1995-166328
Patent literature 2: Japanese Patent Laid-Open Publication No. 1983-19309
Patent literature 3: Japanese Patent Laid-Open Publication No. 1997-193324
Patent literature 4: Japanese Patent No. 4346004

Summary of Invention

Technical Problem

A film on which an inorganic substance has been deposited (sometimes referred to as an "inorganic substance deposited film" hereinafter) is usually stored in a rolled state, and thereafter, on the inorganic substance deposited film, another base material is laminated. This storage is carried out for a long period of time, specifically for not shorter than one week, occasionally for about one month, in a state where between layers of adjacent deposited films in the deposited film having been wound up in layers, the surface on the deposit layer side and the surface on the film side (also referred to as "non-deposition surface" hereinafter) are in contact with each other.

The film composed of an ethylene-based polymer obtained by using a metallocene catalyst, said film being described in the patent literatures 1 to 4, has been improved in bond strength (deposition strength) to an inorganic substance such as aluminum as compared with a film composed of an ethylene-based polymer obtained by using a titanium Ziegler catalyst. However, it can be seen that when the deposited film is stored in a rolled state for a long period of time, the wetting index of the deposit layer surface is lowered, and for example, when the deposited film having been stored for not shorter than one week is laminated with other base material by dry lamination, the bond strength of the deposited film to the other base material is lowered as compared with a case where a deposited film given immediately after production is used.

In order to obtain a deposited film which is not lowered in bond strength of its deposit layer surface to another base material during bonding of them even after the deposited film is stored in a rolled state for a long period time, the present inventors have studied causes of lowering of the wetting index of the deposit layer surface, and as a result, they have found that in a film composed of an ethylene/$\alpha$-olefin copolymer obtained by solution polymerization at a polymerization temperature of not higher than 90°C or an ethylene/$\alpha$-olefin copolymer obtained by vapor phase polymerization, even if said film being a film which is composed of an ethylene/$\alpha$-olefin copolymer obtained by the use of a metallocene catalyst and which has been hitherto thought to less suffer bleed-out of a low-molecular weight component, etc. on the surface, a low-molecular weight component, etc. contained in such an ethylene/$\alpha$-olefin copolymer bleed out on the non-deposition surface and are transferred to the deposit layer surface of the adjacent deposited film in the rolled deposited film to thereby lower the wetting index of the deposit layer surface.

The present invention provides a film for inorganic substance deposition, which does not lower adhesion properties of an inorganic substance deposit surface during dry lamination even after an inorganic substance deposit layer is formed on the film and the film is stored in a rolled state for a long period of time, a deposited film, a production process for the deposited film, and a laminate using the deposited film.

Solution to Problem

The summary of the present invention is as follows.

[1] A film for inorganic substance deposition, comprising single or multiple resin layers, wherein all of the resin layers contain an ethylene-based polymer (A) having a melt tension (MT), as measured at 190°C, of not more than 5.0 g, and the film satisfies the following requirements (1) to (3),

requirement (1) : the amount of a component generated by allowing the film for inorganic substance deposition to stand for not shorter than 7 days under the conditions of 23°C and a relative humidity of 50%, then heating the film at 300°C for 5 minutes in a helium stream, trapping a generated gas at -100°C and then further carrying out heating at 300°C for 2 minutes is not more than 1.2 $\mu$g per milligram of the film for inorganic substance deposition,

requirement (2) : the amount of a compound containing pentavalent phosphorus, said compound being contained in dichloromethane having been used for washing a surface of the film for inorganic substance deposition by the following method and recovered after the washing, is not more than 9 $\mu$g, and

requirement (3): the amount of an oxide of an oligomer of a hexamer to a decamer, said oxide being contained in dichloromethane having been used for washing a surface of the film for inorganic substance deposition by the following method and recovered after the washing, is not more than 1.5 $\mu$g,

(washing method with dichloromethane): a surface of each of two sheets of the film for inorganic substance deposition of A4 size having been allowed to stand for not shorter than 7 days under the conditions of 23°C and a relative humidity of 50% and then inclined at 45° to a horizontal plane, said surface being on the opposite side to the surface where an inorganic substance deposit layer is to be formed, is repeatedly subjected to an operation of washing with 10 mL of dichloromethane three times to wash the surface.

[2] The film for inorganic substance deposition as stated in the above [1], wherein the melt tension (MT) of the ethylene-based polymer (A), as measured at 190°C, is not less than 0.1 g but not more than 5.0 g, and the requirements (1) to (3) are as follows:

requirement (1) : the amount of a component generated by allowing the film for inorganic substance deposition to stand for not shorter than 7 days under the conditions of 23°C and a relative humidity of 50%, then heating the film at 300°C for 5 minutes in a helium stream, trapping a generated gas at -100°C and then further carrying out heating at 300°C for 2 minutes is not less than $1.0 \times 10^{-6}$ µg but not more than 1.2 µg per milligram of the film for inorganic substance deposition,

requirement (2) : the amount of a compound containing pentavalent phosphorus, said compound being contained in dichloromethane having been used for washing a surface of the film for inorganic substance deposition by the following method and recovered after the washing, is not less than $1.0 \times 10^{-6}$ µg but not more than 9 µg, and requirement (3): the amount of an oxide of an oligomer of a hexamer to a decamer, said oxide being contained in dichloromethane having been used for washing a surface of the film for inorganic substance deposition by the following method and recovered after the washing, is not less than $1.0 \times 10^{-6}$ µg but not more than 1.5 µg, (washing method with dichloromethane): a surface of each of two sheets of the film for inorganic substance deposition of A4 size having been allowed to stand for not shorter than 7 days under the conditions of 23°C and a relative humidity of 50% and then inclined at 45° to a horizontal plane, said surface being on the opposite side to the surface where an inorganic substance deposit layer is to be formed, is repeatedly subjected to an operation of washing with 10 mL of dichloromethane three times to wash the surface.

[3] The film for inorganic substance deposition as stated in the above [1] or [2], wherein the ethylene-based polymer (A) is an ethylene-based copolymer obtained by copolymerizing ethylene and an α-olefin of 4 to 10 carbon atoms and satisfying the following requirements (I) and (II) at the same time,

requirement (I): the melt flow rate (MFR), as measured under the conditions of 190°C and a load of 2.16 kg in accordance with ASTM D1238-89, is in the range of 0.1 to 30 g/10 min, and requirement (II): the density (D) is in the range of 870 to 970 kg/m$^3$.

[4] An inorganic substance deposited film comprising an inorganic substance deposit layer composed of an inorganic substance on one surface of the film for inorganic substance deposition as stated in any one of the above [1] to [3]. [5] The inorganic substance deposited film as stated in the above [4], wherein the inorganic substance is at least one kind selected from aluminum, silicon oxide, aluminum oxide, indium oxide and tin oxide. [6] A production process for an inorganic substance deposited film, being a production process for the inorganic substance deposited film as stated in the above [4] and comprising:

a step A of subjecting at least one surface of the film for inorganic substance deposition to one or more treatments selected from a corona treatment, a flame treatment, a plasma treatment and an UV treatment, and a step B of forming, after the step A, the inorganic substance deposit layer on the surface having been subjected to the treatment, by at least one method selected from a vacuum deposition method, a sputtering method and an ion plating method.

[7] A laminated film comprising the inorganic substance deposited film as stated in the above [4] or [5] and a base material layer provided on a surface of the inorganic substance deposit layer, said surface being on the opposite side to the film for inorganic substance deposition. [8] The laminated film as stated in the above [7], wherein the base material layer has been laminated on the inorganic substance deposit layer by using a dry lamination method. [9] A packaging body using the inorganic substance deposited film as stated in the above [4] or [5] or the laminated film as stated in the above [7] or [8]. [10] A film roll obtained by winding the inorganic substance deposited film as stated in the above [4] or [5] into a roll. [11] A production process for a film for inorganic substance deposition comprising single or multiple resin layers, said process comprising a step of forming a resin layer which contains an ethylene-based polymer (A) having a melt tension (MT), as measured at 190°C, of not more than 5.0 g, and satisfies the following requirements (1) to (3) when a resin layer is formed,

requirement (1) : the amount of a component generated by allowing the resin layer to stand for not shorter than 7 days under the conditions of 23°C and a relative humidity of 50%, then heating the resin layer at 300°C for 5 minutes in a helium stream, trapping a generated gas at -100°C and then further carrying out heating at 300°C for 2 minutes is not more than 1.2 μg per milligram of the resin layer,
requirement (2) : the amount of a compound containing pentavalent phosphorus, said compound being contained in dichloromethane having been used for washing a surface of the resin layer by the following method and recovered after the washing, is not more than 9 μg, and
requirement (3): the amount of an oxide of an oligomer of a hexamer to a decamer, said oxide being contained in dichloromethane having been used for washing a surface of the resin layer by the following method and recovered after the washing, is not more than 1.5 μg,
(washing method with dichloromethane): a surface of each of two sheets of the resin layer of A4 size having been allowed to stand for not shorter than 7 days under the conditions of 23 °C and a relative humidity of 50% and then inclined at 45° to a horizontal plane is repeatedly subjected to an operation of washing with 10 mL of dichloromethane three times to wash the surface.

[12] The production process for a film for inorganic substance deposition as stated in the above [11], wherein the melt tension (MT) of the ethylene-based polymer (A), as measured at 190 °C, is not less than 0.1 g but not more than 5.0 g, and the requirements (1) to (3) are as follows:

requirement (1) : the amount of a component generated by allowing the resin layer to stand for not shorter than 7 days under the conditions of 23°C and a relative humidity of 50%, then heating the resin layer at 300°C for 5 minutes in a helium stream, trapping a generated gas at -100°C and then further carrying out heating at 300°C for 2 minutes is not less than $1.0 \times 10^{-6}$ μg but not more than 1.2 μg per milligram of the resin layer,
requirement (2) : the amount of a compound containing pentavalent phosphorus, said compound being contained in dichloromethane having been used for washing a surface of the resin layer by the following method and recovered after the washing, is not less than $1.0 \times 10^{-6}$ μg but not more than 9 μg, and
requirement (3): the amount of an oxide of an oligomer of a hexamer to a decamer, said oxide being contained in dichloromethane having been used forwashinga surface of the resin layer by the following method and recovered after the washing, is not less than $1.0 \times 10^{-6}$ μg but not more than 1.5 μg,
(washing method with dichloromethane): a surface of each of two sheets of the resin layer of A4 size having been allowed to stand for not shorter than 7 days under the conditions of 23°C and a relative humidity of 50% and then inclined at 45° to a horizontal plane is repeatedly subjected to an operation of washing with 10 mL of dichloromethane three times to wash the surface.

Advantageous Effects of Invention

When an inorganic substance deposited film obtained by depositing an inorganic substance on one surface of the film for inorganic substance deposition according to the present invention is stored by superposing the deposited film on another deposited film in such a manner that between the adjacent inorganic substance deposited films, the inorganic deposit layer faces the film for inorganic substance deposition (that is, non-deposition surface of the inorganic substance deposited film), for example, when the inorganic substance deposited film is stored in a rolled state, lowering of wettability of the inorganic substance deposit layer surface is inhibited even if the film is stored for a long period of time. On this account, even if other base material is laminated on the inorganic substance deposit layer of the inorganic substance deposited film having been stored in a superposed state for a long period of time as described above, adhesive strength between the inorganic substance deposit layer and the other base material is high as compared with a case of using a conventional inorganic substance deposited film, and as a result, heat-sealing failures such as delamination and lowering of heat-sealing strength are markedly decreased. Moreover, ink adhesion to the inorganic substance deposit layer surface becomes better than that in a conventional inorganic substance deposited film, and the printing condition is improved, so that printing failures are markedly decreased.

Description of Embodiments

The present invention is described in more detail hereinafter.
In the present invention, a thin film which is composed of an inorganic substance and provided on one surface of the film for inorganic substance deposition is sometimes referred to for convenience as an "inorganic substance deposit layer" or a "deposit layer" simply, regardless of whether the method for forming the thin film is a deposition method or not.

A film for providing an inorganic substance deposit layer on its surface is sometimes referred to for convenience as a "film for inorganic substance deposition" or a "film for deposition" simply, regardless of whether the method for forming the film is a deposition method or not.

[Film for inorganic substance deposition]

The film for inorganic substance deposition according to the present invention is a film for inorganic substance deposition, comprising single or multiple resin layers, wherein all of the resin layers contain an ethylene-based polymer (A) having a melt tension, as measured at 190°C, of not more than 5.0 g, and the film satisfies the later-described requirements (1) to (3).

<Ethylene-based polymer (A)>

The melt tension of the ethylene-based polymer (A), as measured at 190°C, is not more than 5.0 g, preferably not more than 4.5 g, more preferably not more than 4.0g. This value is more specifically a value measured by a method adopted in the later-described working examples or a method equivalent thereto.

In the ethylene-based polymer (A), the number of long-chain branches causing lowering of mechanical strength is small, and therefore, sealing strength of a film containing such an ethylene-based polymer (A) is good. In general, film strength and sealing strength are sometimes lowered by the presence of long-chain branches in an ethylene-based polymer used for a film, but since the film for inorganic substance deposition according to the present invention uses the ethylene-based polymer (A) having a melt tension, as measured at 190°C, of not more than 5.0 g, mechanical strength of the film is good.

The melt tension of the ethylene-based polymer (A), as measured at 190°C, is preferably not less than 0.1 g, more preferably not less than 0.3 g. If the melt tension is less than 0.1 g, stability during melting is bad, and film production tends to become difficult.

The melt tension of the ethylene-based polymer (A) can be decreased by, for example, not using high-pressure-processed LDPE but using LLDPE that is produced by polymerization using a catalyst under the conditions of medium pressure or low pressure.

The ethylene-based polymer (A) having been formed into a film preferably satisfies the following requirements (I) to (III).

Requirement (I) : The melt flow rate (MFR) of the ethylene-based polymer (A), as measured under the conditions of 190°C and a load of 2.16 kg in accordance with ASTM D1238-89, is usually not less than 0.1 g/10 min but not more than 30 g/10 min.

The lower limit is more preferably 0.5 g/10 min, still more preferably 0.7 g/10 min, much more preferably 1.0 g/10 min, and the upper limit is more preferably 28 g/10 min, still more preferably 25 g/10 min. When the melt flow rate (MFR) is higher than the lower limit, extrudability of a material containing the ethylene-based polymer (A) is good, and film-forming properties are good. When the melt flow rate is lower than the upper limit, strength of the film, such as sealing strength thereof, is excellent.

The melt flow rate (MFR) of an ethylene-based polymer strongly depends upon amolecularweight . As the melt flow rate (MFR) decreases, the molecular weight becomes higher, and as the melt flow rate (MFR) increases, the molecular weight becomes lower. Further, it is known that the molecular weight of an ethylene-based polymer is determined by a compositional ratio of hydrogen to ethylene (hydrogen/ethylene) in the polymerization system (e.g., Kazuo SOGA, et al., "Catalytic Olefin Polymerization", Kodansha scientific, 1990, p. 376). On this account, by increasing or decreasing the hydrogen/ethylene ratio, the melt flow rate (MFR) of an ethylene-based polymer can be increased or decreased.

Requirement (II): The density of the ethylene-based polymer (A) is usually not less than 870 kg/m$^3$ but not more than 970 kg/m$^3$.

The lower limit of the density is preferably 880 kg/m$^3$, more preferably 885 kg/m$^3$, and the upper limit of the density is preferably 965 kg/m$^3$, more preferably 960 kg/m$^3$. When the density is not less than the lower limit, a film of the ethylene-based polymer (A) has less stickiness, and processability and anti-blocking properties of the film are excellent. When the density is not more than the upper limit, strength (including sealing strength) of the film is excellent.

The density of the ethylene-based polymer (A) depends upon the $\alpha$-olefin content in the ethylene-based polymer (A). As the $\alpha$-olefin content decreases, the density becomes higher, and as the $\alpha$-olefin content increases, the density becomes lower. Further, it is known that the $\alpha$-olefin content in the ethylene-based polymer (A) is determined by a compositional ratio of an $\alpha$-olefin to ethylene ($\alpha$-olefin/ethylene) in the polymerization system (e.g., Walter Kaminsky, Makromol. Chem., 193, p. 606 (1992)). On this account, by increasing or decreasing the $\alpha$-olefin/ethylene

ratio, an ethylene-based polymer having a density of the above range can be produced.

The density of the ethylene-based polymer (A) can be measured by a density gradient tube method after strands obtained in the MFR measurement are heat-treated at 100°C for one hour and allowed to stand for one hour at room temperature in accordance with JIS K7112.

Requirement (III): The ratio (Mw/Mn) of a weight-average molecular weight (Mw) of the ethylene-based polymer (A) to a number-average molecular weight (Mn) thereof, said Mw and Mn being measured by GPC, is usually not less than 1.5 but not more than 6.0.

The lower limit of Mw/Mn is more preferably 1.6, still more preferably 1.7, and the upper limit of Mw/Mn is more preferably 5.9, still more preferably 5.8, particularly preferably 5.7. When Mw/Mn is not more than the upper limit, the amount of a low-molecular weight component is small, and a film of the ethylene-based polymer (A) has less stickiness and has good stain resistance. When Mw/Mn is not less than the lower limit, extrudability of the ethylene-based polymer is good.

The value of the ratio (Mw/Mn) of a weight-average molecular weight (Mw) of the ethylene-based polymer (A) to a number-average molecular weight (Mn) thereof is a value measured in the following manner using Waters GPC-150C.

Separation column: TSKgel GMH6-HT x 2 and TSKgel GMH6-HTL x 2
Column size: each, inner diameter 7.5 mm, length 300 mm
Column temperature: 140°C
Mobile phase: o-dichlorobenzene, and as antioxidant, BHT (dibutylhydroxytoluene) of 0.025% by weight
Moving rate: 1.0 ml/min
Sample concentration: 0.15% by weight
Sample injection quantity: 500 $\mu$l
Detector: differential refractometer
Standard polystyrene: monodisperse polystyrene (molecular weight: 495 to 20,600,000) manufactured by Tosoh Corporation
Molecular weight: molecular weight in terms of polyethylene, having been subjected to universal calibration

The ethylene-based polymer (A) is an ethylene homopolymer or an ethylene copolymer, and when it is an ethylene copolymer, it is preferably a copolymer of ethylene and an $\alpha$-olefin of not less than 4 but not more than 10 carbon atoms, more preferably a copolymer of ethylene and an $\alpha$-olefin of 6 to 10 carbon atoms. When an $\alpha$-olefin of 4 carbon atoms is used, it is preferable to use an $\alpha$-olefin of 6 to 10 carbon atoms in combination. Examples of the $\alpha$-olefins of 4 to 10 carbon atoms for use in the copolymerization with ethylene include 1-butene, 1-hexene, 4-methyl-1-pentene, 1-octene and 1-decene.

The ethylene-based polymer (A) contains constituent units derived from ethylene usually in amounts of 50 to 100% by mol, more preferably 70 to 100% by mol, and contains constituent units derived from an $\alpha$-olefin of 4 to 10 carbon atoms usually in amounts of 0 to 50% by mol, more preferably 0 to 30% by mol (with the proviso that the total amount of both the constituent units is 100% by mol).

<Production process for ethylene-based polymer (A)>

The ethylene-based polymer (A) can be produced by a high-temperature solution method using a Ziegler catalyst or a metallocene catalyst. The high-temperature solution method is a method in which using hexane or the like as a solvent and carrying out pressurization, a polymer is produced in a homogeneous state at a high temperature. In the high-temperature solutionmethod, reaction is carried out in a homogeneous phase, so that the resulting ethylene-based polymer (A) has a small composition distribution, and as a result, formation of an oligomer or formation of other volatile compounds can be suppressed. Further, a solvent such as hexane is removed by flashing it at atmospheric pressure, and a polymer precipitated is dried separately. Also during the flashing, an oligomer and volatile compounds are removed together with the solvent. When the ethylene-based polymer (A) is industrially produced by the high-temperature solution method, it is preferable to adopt a continuous process in which a solvent and a raw material monomer are continuously fed and the above flashing operation is repeatedly carried out to collect the product and the raw material monomer.

Accordingly, a film of the ethylene-based polymer (A) obtained by the high-temperature solution method has a characteristic of an extremely small amount of a component that bleeds out from the film.

<Arbitrary components>

The resin layers to constitute the film for inorganic substance deposition according to the present invention may arbitrarily contain additives, such as an antioxidant and/or an oxide thereof, and a surface active agent.

Examples of commercial products of the antioxidants include Irgafos 168 (trade name), Irganox 1076 (trade name), Irganox 1010 (trade name) and Sumilizer GP (trade name).

When such an antioxidant is contained in the film for inorganic substance deposition according to the present invention, the antioxidant is oxidized in preference to the ethylene-based polymer (A), whereby oxidation of the ethylene-based polymer (A) is prevented. If the antioxidant is a phosphorus-based antioxidant containing phosphorus of an oxidation number III, the oxidation number of phosphorus is changed to V from III by the oxidation of the antioxidant.

Examples of the surface active agents include cationic surface active agents, nonionic surface active agents and anionic surface active agents, and preferable are aliphatic amides, alkyl oxides, etc.

<Properties of film for inorganic substance deposition>

The film for inorganic substance deposition according to the present invention satisfies the following requirements (1) to (3).

Requirement (1): The amount of a component (also referred to as a "low-molecular weight component" hereinafter) generated by allowing the film for inorganic substance deposition (or the later-described inorganic substance deposited film) to stand for not shorter than 7 days under the conditions of 23°C and a relative humidity of 50%, then heating the film at 300°C for 5 minutes in a helium stream, trapping a generated gas at -100°C and then further carrying out heating at 300°C for 2 minutes is not more than 1.2 $\mu$g per milligram of the film for inorganic substance deposition. This amount is a value obtained by analyzing the low-molecular weight component by gas chromatography and determining the component in terms of an ethylene oligomer of a decamer as a standard substance.

The mass of the deposit layer of the inorganic substance deposited film is negligibly small as compared with the mass of the film for inorganic substance deposition, and therefore, the amount of the low-molecular weight component per milligram of the inorganic substance deposited film is substantially the same as the amount of the low-molecular weight component per milligram of the film for inorganic substance deposition.

The amount of the low-molecular weight component is preferably not more than 1.1$\mu$g, more preferably not more than 1.0$\mu$g, per milligram of the film for inorganic substance deposition. The amount of the low-molecular weight component is, for example, not less than $1.0 \times 10^{-6}$ $\mu$g, more specifically not less than $1.0 \times 10^{-5}$ $\mu$g, per milligram of the film for inorganic substance deposition.

The low-molecular weight component is a component which bleeds out (undergoes bleed-out) from the film for inorganic substance deposition when a deposited film having an inorganic substance deposit layer on one surface of the film for inorganic substance deposition is stored in a rolled state at 23°C for not shorter than 7 days. If the amount of the low-molecular weight component is large, the low-molecular weight component of a large amount bleeds out from the film for inorganic substance deposition of the rolled inorganic substance deposited film and is transferred to the surface of the inorganic substance deposit layer of layers of the adjacent inorganic substance deposited film, whereby the wetting index of the inorganic substance deposit layer surface is largely decreased.

By using the ethylene-based polymer (A) as a film-forming resin, and by adding no substance that easily migrates onto a film surface, such as an additive of such a type as bleeds and exerts performance, e.g., slip agent, to the ethylene-based polymer (A), and by forming the polymer into a film at a resin temperature of not higher than 250°C, the film for inorganic substance deposition satisfying the requirement (1) can be produced.

Requirement (2) : The amount of a compound containing pentavalent phosphorus, said compound being contained in dichloromethane having been used for washing a surface of a non-deposition layer (surface where no inorganic substance is deposited) of the film for inorganic substance deposition (or the later-described inorganic substance deposited film) by the following method and recovered after the washing, is not more than 9 $\mu$g.

The amount of the compound containing pentavalent phosphorus is preferably not more than 8 $\mu$g. Further, the amount of the compound containing pentavalent phosphorus is, for example, not less than $1.0 \times 10^{-6}$ $\mu$g, more specifically not less than $1.0 \times 10^{-5}$ $\mu$g. If the amount thereof is intended to be decreased to a value of the lower limit or less, unfavorable influence (restriction) is sometimes exerted on the amounts of other additives or the addition of a polymerization catalyst and a polymerization initiator in polymerization for obtaining the polymer (A).

(Washing method with dichloromethane): A surface (whole surface) of each of two sheets of the film for inorganic substance deposition of A4 size having been allowed to stand for not shorter than 7 days under the conditions of 23°C and a relative humidity of 50% and then inclined at 45° to a horizontal plane, said surface being on the opposite side to the surface where an inorganic substance deposit layer is to be formed, is repeatedly subjected to an operation of washing with 10 mL of dichloromethane at room temperature (25°C) three times to wash the surface.

The film for inorganic substance deposition according to the present invention is sometimes formed from a material obtained by adding an additive such as an antioxidant to the ethylene-based polymer (A). The additive can be oxidized after it is added. The additive or an oxide thereof sometimes bleeds out on a surface of the film for inorganic substance deposition according to the present invention.

If an oxide of a phosphorus-based antioxidant, said oxide being the compound containing pentavalent phosphorus, is present on the inorganic substance deposit layer of the inorganic substance deposited film according to the present invention, polarity of the oxide of a phosphorus-based antioxidant has influence on the wettability of the inorganic substance deposit layer. The oxide of a phosphorus-based antioxidant occurs by being transferred to the deposit surface from the non-deposition surface when the inorganic substance deposited film produced is rolled up. Accordingly, it is undesirable that the oxide of a phosphorus-based antioxidant is present in an amount more than a fixed amount on the surface of the film for inorganic substance deposition from the viewpoint that when the inorganic substance deposited film obtained by depositing an inorganic substance on one surface of the film for inorganic substance deposition according to the present invention is stored in a superposed state such as a rolled state, transfer of the oxide of a phosphorus-based antioxidant from the surface of the film for inorganic substance deposition in the inorganic substance deposited film to the surface of the inorganic substance deposit layer of the deposited film, said layer being superposed on the surface of the film for inorganic substance deposition, is prevented.

When the whole of the non-deposition surface of the film for inorganic substance deposition composed of a material containing the ethylene-based polymer (A) is washed with dichloromethane, the component having bled out on the surface of the film for inorganic substance deposition can be separated from the film for inorganic substance deposition. The component thus separated can be identified and quantified by publicly known analytical means.

Although the amount of the component that bleeds out is usually an extremely slight amount, the presence of phosphorus contained in the component can be confirmed by inorganic analysis due to inductively coupled plasma atomic emission spectrometry (ICP-AES) or inductively coupled plasma mass spectrometry (ICP-MS). The phosphorus compound, the presence of which has been confirmed, can be identified by measurement of a molecular weight due to FD-MS or by a mass spectrometer (GC-MS, LC-MS) connected inline to gas chromatography or liquid chromatography, and an oxide of the phosphorus compound can be also sometimes identified together. Determination of the amount of compound containing pentavalent phosphorus can be carried out by, for example, a method adopted in the later-described working examples or a method equivalent thereto. If the compound containing pentavalent phosphorus to be subjected to measurement cannot be obtained as a standard reagent in GC-MS or LC-MS, a compound containing trivalent phosphorus before oxidized may be used as an indication of quantification.

In order to analyze whether phosphorus is trivalent or pentavalent, $^{31}$P-NMR may be used, or ion chromatography/ICP/MS or the like may be used.

The amount of the compound containing pentavalent phosphorus can be decreased by decreasing the amount of a phosphorus-based antioxidant or flame retardant based on the ethylene-based polymer (A) or by carrying out forming for the film for inorganic substance deposition at a low temperature so that the phosphorus-based antioxidant should not be changed to a compound containing pentavalent phosphorus.

Requirement (3): The amount of an oxide of an oligomer of a hexamer to a decamer, said oxide being contained in dichloromethane having been used for washing a surface of the film for inorganic substance deposition by the following method and recovered after the washing, is not more than 1.5 μg.

The amount of the oxide of the oligomer is preferably not more than 1.0 μg, most preferably a detection limit or less. Further, the amount of the oxide of the oligomer is, for example, not less than $1.0 \times 10^{-6}$ μg, more specifically not less than $1.0 \times 10^{-5}$ μg. If the amount thereof is intended to be decreased to a value of the lower limit or less, unfavorable influence (restriction) is sometimes exerted on the amounts of other additives or the addition of a polymerization catalyst and a polymerization initiator in polymerization for obtaining the polymer (A).

The oxide of the oligomer can be quantified by, for example, a method adopted in the later-described working examples or a method equivalent thereto.

Differently from a low-molecular weight compound, such as methane, water or sodium chloride, a polymer is produced having a molecular weight of a certain width due to the characteristics of the synthesis method. In a polymer, therefore, an oligomer having a relatively lower molecular weight than a main component is contained in many cases. When a film or the like is prepared by using a polymer, an oligomer contained in the polymer sometimes bleeds out on the film surface. It has been found that not a usual oligomer that is generally observed but an oxidized oligomer has high staining properties particularly against the inorganic substance deposit layer in the present invention. Since the oxidized oligomer has a lower molecular weight than the main component similarly to an oligomer, it easily migrates inside the film, and since it has been oxidized, it has a polar group such as carbonyl group, so that the oxidized oligomer has a characteristic of easy adhesion to the inorganic substance deposit layer. On that account, the oxidized oligomer stains the inorganic substance deposit layer particularly strongly as compared with a generally known oligomer, and has a high adhesive force, so that it becomes difficult to wash away the oxidized oligomer. This tends to exert evil influence on laminating of the deposited film and another film using an adhesive.

By using the ethylene-based polymer (A) as a film-forming resin, and by adding no substance that easily migrates onto a film surface, such as an additive of such a type as bleeds and exerts performance, e.g., slip agent, to the ethylene-based polymer (A), and by forming the polymer into a film at a resin temperature of not higher than 250°C, the film for inorganic substance deposition satisfying the requirement (3) can be produced.

The film for inorganic substance deposition according to the present invention preferably further satisfies the following requirement (4).

Requirement (4) : The amount of a surface active agent sometimes contained in the film for inorganic substance deposition according to the present invention is preferably not more than 0.1% by weight based on 100% by weight of the film for inorganic substance deposition.

The surface active agent can be identified by extracting it from the film for inorganic substance deposition according to the present invention by a Soxhlet method using an acetone/hexane (1/1=v/v) mixed solvent, then concentrating the extract by an evaporator and performing TLC fractionation, and if necessary, it can be identified and quantified froma retention time, a peak intensity and a calibration curve in the HPLC measurement.

The film for inorganic substance deposition according to the present invention may be a single layer film or may be a multilayer film of two or more layers.

When the film for inorganic substance deposition is a multilayer film, a layer composed of the ethylene-based polymer (A) is used as each of the layers, and the density of the ethylene-based polymer used in each of the layers is usually in the range of 870 to 970 kg/m$^3$.

When a deposited film in which an inorganic substance is deposited on the film for inorganic substance deposition according to the present invention is used as a sealant film of a packaging material, the film for inorganic substance deposition according to the present invention may be formed as a two-layer film in which as the ethylene-based polymer (A) for use in a sealing layer (non-deposition surface),an ethylene-based polymer (A) having a lower density than the ethylene-based polymer (A) for use in a deposition target layer (deposition target surface) is used, in order to obtain stable low-temperature heat-sealing properties.

When the film for inorganic substance deposition according to the present invention is a multilayer film in which three or more ethylene-based polymer layers are laminated, it is desirable that the ethylene-based polymer used in each layer is the ethylene-based polymer (A) and the density of the ethylene-based layer (A) for use in the intermediate layer is higher than the density of the ethylene-based polymer (A) for use in the outermost layer, as long as the film-forming properties for the film for inorganic substance deposition, the processability in providing a deposit layer on the resulting film for inorganic substance deposition, the processability of the film for inorganic substance deposition, and the quality of the film for inorganic substance deposition as a packaging material are not impaired.

The thickness of the film for inorganic substance deposition according to the present invention is properly determined according to the use application, but is usually in the range of 5 to 1000 μm, preferably 8 to 300 μm, more preferably 10 to 100 μm. In the film for inorganic substance deposition, the surface on which an inorganic substance is to be deposited (deposition target surface) may have been subjected to surface treatment, such as corona treatment, flame treatment, plasma treatment or primer coating treatment, in order to improve adhesion to the inorganic substance to be deposited. When the film for inorganic substance deposition according to the present invention is a single layer film, a layer surface on which the inorganic substance deposit layer is to be formed is sometimes referred to as a "deposition target layer surface", and a layer surface on which the inorganic substance deposit layer is not formed is sometimes referred to as a "non-deposition layer surface" in the present invention. When the film for inorganic substance deposition according to the present invention is a multilayer film of two or more layers, a layer, on a surface of which the inorganic substance deposit layer is to be formed, among the layers to constitute the multilayer film is sometimes referred to as a "deposition target layer" or a "laminate layer", and a layer, on a surface of which the inorganic substance deposit layer is not formed, is sometimes referred to as a "thermal bonding layer" in the present invention.

The film for inorganic substance deposition according to the present invention can be produced by publicly known various production processes, and specifically, the film can be produced by, for example, a T-die film forming machine or an inflation film forming machine using the ethylene-based polymer (A). When a multilayer film is obtained as the film for inorganic substance deposition, the film can be produced by co-extrusion using a multilayer die of a two-layer structure, a three-layer structure or the like. Above all, T-die forming is preferable from the viewpoint of thickness accuracy.

The production process for a film for inorganic substance deposition according to the present invention includes a step of forming a resin into single or multiple resin layers, said resin containing an ethylene-based polymer (A) having a melt tension (MT), as measured at 190°C, of not more than 5.0g, and satisfying the following requirements (1) to (3) when the resin is formed into a resin layer,

requirement (1) : the amount of a component generated by allowing the resin layer to stand for not shorter than 7 days under the conditions of 23°C and a relative humidity of 50%, then heating the resin layer at 300°C for 5 minutes in a helium stream, trapping a generated gas at -100°C and then further carrying out heating at 300°C for 2 minutes is not more than 1.2 μg per milligram of the resin layer,

requirement (2) : the amount of a compound containing pentavalent phosphorus, said compound being contained in dichloromethane having been used for washing a surface of the resin layer by the following method and recovered after the washing, is not more than 9 μg, and

requirement (3): the amount of an oxide of an oligomer of a hexamer to a decamer, said oxide being contained in dichloromethane having been used for washing a surface of the resin layer by the following method and recovered after the washing, is not more than 1.5 μg,

(washing method with dichloromethane): a surface of each of two sheets of the resin layer of A4 size having been allowed to stand for not shorter than 7 days under the conditions of 23°C and a relative humidity of 50% and then inclined at 45° to a horizontal plane is repeatedly subjected to an operation of washing with 10 mL of dichloromethane three times to wash the surface.

Details of the requirements (1) to (3) are as previously described.

The production process for a film for inorganic substance deposition according to the present invention may be that of another embodiment including a step in which a resin composition containing an ethylene-based polymer having a melt tension (MT), as measured at 190°C, of not more than 5.0g is confirmed to satisfy the requirements (1) to (3) when the resin composition is formed into a resin layer, and the resin composition having been confirmed to satisfy the above requirements is formed into single or multiple resin layers. In such a production process for a film for inorganic substance deposition, it has been confirmed in the selection of a raw material that the raw material satisfies the requirements (1) to (3) when it is formed into a resin layer, and therefore, the resulting film for inorganic substance deposition exhibits the aforesaid effects of the present invention.

[Inorganic substance deposited film]

The inorganic substance deposited film according to the present invention is a film having a deposit layer composed of an inorganic substance on one surface (deposition target layer) of the above-mentioned film for inorganic substance deposition.

The inorganic substance deposited film according to the present invention is sometimes stored in a rolled state. During the storage, between layers of the adjacent inorganic film deposited films, a surface of the inorganic substance deposit layer and a non-deposition surface of the film for inorganic substance deposition (that is, film containing the ethylene-based polymer (A)) are brought into contact with each other for a long period of time, specifically for not shorter than one week, occasionally for about one month. In the inorganic substance deposited film of the present invention using the film for inorganic substance deposition satisfying the aforesaid requirements (1) to (3), wetting index of the inorganic substance deposit layer surface is less lowered even when the film is stored in a rolled state for a long period of time, specifically for not shorter than one week, as described above. More specifically, before the film is rolled up, the wetting index of the inorganic substance deposit layer surface is, for example, about 60 dyn, and after the film is allowed to stand in a rolled state for not shorter than one week, the wetting index of the inorganic substance deposit layer surface is preferably not less than 32 dyn, more preferably not less than 35 dyn.

<Inorganic substance>

The inorganic substance is not specifically restricted provided that it is an inorganic substance capable of being deposited on the film for inorganic substance deposition. Examples of such inorganic substances include metals, such as Mg, A1, Si, Ca, Sc, Ti, V, Cr, Mn, Fe, Co, Ni, Cu, Zn, Rb, Sr, Y, Nb, Zr, Mo, Ag, Cd, In, Sn, Sb, Cs, Ba, La, Ta, Hf, W, Ir, Tl, Pb, Bi and rare earth metals, and oxides, nitrides, nitroxides, sulfides and phosphides of these metals. These may be used singly or may be used in combination of two or more kinds. Si, Sb and the like are generally classified as semi-metals in some cases, but in the present invention, they are regarded as metals.

As the inorganic substances, preferable are aluminum, silica (silicon oxide), alumina (aluminum oxide), zirconia (zirconia oxide) and titania (titanium oxide), and more preferable are aluminum, silica and alumina.

On the surface of the film for inorganic substance deposition, the inorganic substance is present as structures of dispersed or aggregated fine particles or is present as a structure of a film.

From the viewpoint of impartation of gas barrier properties to the deposited film, the thickness of the deposit layer is usually not less than 10 Å, preferably not less than 20 Å, and from the viewpoint of impartation of flex resistance to the deposited film, it is usually not more than 5000 Å, preferably not more than 3000 Å.

<Production process for inorganic substance deposited film>

The inorganic substance deposited film according to the present invention can be produced by depositing an inorganic substance on a surface of the film for inorganic substance deposition (surface of a laminate layer in the case where the film for inorganic substance deposition is a multilayer film) according to the present invention and thereby forming a thin film of the inorganic substance (that is, inorganic substance deposit layer).

For forming a thin film of the inorganic substance on the surface of the film for deposition, publicly known various methods can be adopted, and examples of the methods include chemical deposition methods, such as chemical deposition (CVD), low-pressureCVDandplasma CVD, physical deposition methods (PVD), such as vacuum deposition (reactive vacuum deposition), sputtering (reactive sputtering) and ion plating (reactive ion plating), and plasma display methods, such as low-pressure plasma display and plasma display.

When the inorganic substance deposit layer is formed by the above methods, steps other than a step that is carried out under vacuum are carried out in the presence of an inert gas such as nitrogen at a temperature as low as possible for a short treatment time, whereby formation of an oxide derived from the ethylene-based polymer (A) for constituting the film for deposition can be suppressed.

In order to remove static electricity of the film for inorganic substance deposition or to enhance adhesion between the film for inorganic substance deposition and the inorganic substance deposit layer, the surface of the film for inorganic substance deposition may be subjected to plasma treatment before deposition. Examples of methods to generate plasma include direct current glow discharge, high-frequency discharge and microwave discharge. For the discharge, introduction of a gas into a deposition tank is necessary, and examples of such gases include various gases generally used in discharge, such as argon, helium, oxygen and nitrogen.

Immediately before the deposition is carried out, foreign matters adhering to a deposition surface of the film for inorganic substance deposition according to the present invention may be removed by using an ultrasonic dry cleaner.

The deposited film of the present invention can be used as a packaging film.

[Laminated film]

The laminated film of the present invention is a film obtained by laminating (bonding) a base material layer onto the inorganic substance deposit layer surface of the inorganic substance deposited film according to the present invention.

The inorganic substance deposited film according to the present invention uses, as a film for inorganic substance deposition, the aforesaid film for inorganic substance deposition according to the present invention, and therefore, even if the inorganic substance deposit layer of the inorganic substance deposited film having been stored in a rolled state for a long period of time is laminated with a base material layer by dry lamination, laminating strength between the inorganic substance deposit layer surface and the base material is less lowered because the oligomer has not been transferred to the inorganic substance deposit layer surface or has been transferred in an extremely small amount. Moreover, when the laminated film of the present invention is used as a packaging material, lowering of heat-sealing strength can be particularly suppressed.

<Base material layer>

As the base material layer, a film composed of, for example, paper or a thermoplastic resin can be mentioned.

Examples of the thermoplastic resins include publicly known various thermoplastic resins, such as polyolefins (polyethylene, polypropylene, poly-4-methyl-1-pentene, polybutene, etc.), polyesters (polyethylene terephthalate, polybutylene terephthalate, polyethylene naphthalate, etc.), polyamides (nylon-6, nylon-66, poly(meta-xylene adipamide), etc.), polyvinyl chloride, polyimide, ethylene/vinyl acetate copolymer, polyacrylonitrile, polycarbonate, polystyrene, ionomer, and mixtures of these resins. Of these, preferable are thermoplastic resins having good stretchability and transparency, such as polypropylene, polyethylene terephthalate and polyamide.

The film composed of the thermoplastic resin may be a non-stretched film or may be a stretched film. Above all, a biaxially oriented film is preferable because it has excellent rigidity. On the base material layer, printing may have been made, when needed.

<Production process for laminated film>

The laminated film according to the present invention can be produced by laminating the inorganic substance deposited film of the present invention with the base material via the inorganic substance deposit layer. As the laminating techniques, publicly known various production processes can be mentioned, and extrusion lamination, dry lamination, etc. can be mentioned.

Examples

The present invention is more specifically described with reference to the following examples, but it should be construed that the present invention is in no way limited to those examples.

Property values, etc. in the examples and the comparative examples were determined by the following measuring methods.

(Measuring methods)

«Ethylene-based polymer»

<Melt tension>

Melt tension (MT) was determined by measuring a stress given when a molten ethylene-based polymer is stretched at a given rate. In the measurement, MT measuring machine manufactured by Toyo Seiki Seisaku-sho Ltd. was used. The measurement was carried out under the measuring conditions of a resin temperature of 190°C, a melting time of 6 minutes, a barrel diameter of 9.55 mmø, an extrusion rate of 15 mm/min, a take-up rate of 24 m/min (when a molten filament is broken, the take-up rate is decreased by 5 m/min each), a nozzle diameter of 2.095 mmø and a nozzle length of 8 mm.

<MFR>

MFR was measured at 190°C under a load of 2.16 kg in accordance with JIS K6760.

<Density>

Density was measured in accordance with JIS K6760.

<Molecular weight distribution>

Measurement was carried out under the following conditions.

Analysis software: Chromatography data system Empower (Waters Corporation)
Column: TSKgel GMH6-HT x 2 + TSKgel GMH6-HTL x 2

(7.5 mm (inner diameter) x 30 cm (length), Tosoh Corporation)

Mobile phase: o-Dichlorobenzene (Wako Pure Chemical Industries, Ltd., special grade reagent), and as antioxidant, BHT (dibutylhydroxytoluene) of 0.025% by weight
Detector:differential refractometer(equipment built-in type)
Column temperature: 140°C
Flow rate: 1.0 mL/min
Injection quantity: 500 μL
Sampling time interval: 1 second
Sample concentration: 0.15% (w/v)
Molecular weight calibration: monodisperse polystyrene (Tosoh Corporation)/molecular weight 495 to molecular weight 20,600,000

In accordance with a procedure of universal calibration described in Z. Crubisic, P. Rempp, H. Henoit, J. Polym. Sci., B5, 753 (1967), a molecular weight distribution curve in terms of a molecular weight of polyethylene was prepared, and from this molecular weight distribution curve, a weight-average molecular weight Mw and a number-average molecular weight Mn were calculated, and a ratio thereof (Mw/Mn) was taken as a molecular weight distribution.

«Production process for film for inorganic substance deposition»

A film for inorganic substance deposition of three layers of one material or three layers of two materials was prepared under the following conditions.

Forming machine: 3 cast forming machines of 65 memø manufactured by Modern Machinery Co., Ltd.
Screw: barrier type screw
Die: 800 mm (width), 1.6 mm (lip width)
Forming temperature: temperature in the range of 180°C to 250 °C, at which film production is stabilized
Chill roll temperature: 60°C [layer brought into contact with the chill roll is on the deposition target layer (laminate layer) side]
Layer constitution: deposition target layer (laminate layer)/intermediate layer/sealing layer (non-deposition layer) = 10/20/10 (μm)
Take-off rate: 50 m/min

The deposition target layer surface of the film for inorganic substance deposition prepared was subjected to corona treatment in such a manner that the wetting tension of the surface became not less than 43 dyn.

«Production process for inorganic substance deposited film»

Aluminum was evaporated by heating under vacuum of not more than $10^{-4}$ Torr by a high-frequency induction heating system and continuously deposited on the deposition target surface of the film for inorganic substance deposition at a deposition rate of 10 m/min to obtain an inorganic substance deposited film having an aluminum deposit layer thickness of 500 Å.

<Amount of low-molecular weight component>

The film for inorganic substance deposition was allowed to stand for not shorter than 7 days under the conditions of 23°C and a relative humidity of 50% and then heated to 300°C to generate a gas. The gas generated was analyzed by gas chromatography, and a value obtained by determination in terms of an ethylene oligomer of a decamer as a standard substance was taken as an amount of a low-molecular weight component generated. That is to say, analysis by gas chromatography was carried out, and by the use of a calibration curve prepared by using an ethylene oligomer of a decamer and showing a relationship between a detection peak and the actual amount of the ethylene oligomer of a decamer, an amount of a low-molecular weight component generated was calculated from the total peak detected by gas chromatography.

In the analysis by gas chromatography, specifically, 5 mg of the film for inorganic substance deposition having been allowed to stand for not shorter than 7 days under the conditions of 23°C and a relative humidity of 50% after forming was accurately weighed into a sample container and heated at 300 °C for 5 minutes in a helium stream, and a gas generated was trapped at -100°C. This was heated at 300 °C for 2 minutes and subjected to GC/MS analysis. The measuring conditions are as follows.

TDS

Apparatus: GERSTEL TDS apparatus
TDS: 300°C x 5 minutes
CIS: trap temperature -100°C, desorption temperature 300°C x 2 minutes

GC/MS

Apparatus: Agilent 6890N/5973-GC/MS
Column: ZB-1 30 m x 0.32 mm
Sample quantity: 5 to 6 mg

<Compound containing pentavalent phosphorus>

After films for inorganic substance deposition (A4 size × 2 films) were produced by forming, they were allowed to stand for 7 days under the conditions of 23°C and a relative humidity of 50%.

Subsequently, an operation of washing the non-deposition surface (sealing layer surface) of each of the films for inorganic substance deposition with 10 mL of dichloromethane using a pipette was repeated three times, and the wash liquid was concentrated up to 10 mL by an evaporator. The resulting solution was subjected to gas chromatography, and Sumilizer GP (manufactured by Sumitomo Chemical Co., Ltd.) having been added to the films for inorganic substance deposition and an oxide thereof were identified by the retention time, and the oxide was quantified in terms of Sumilizer GP. The measuring conditions, etc. are as follows.

Apparatus: Agilent Technologies GC 6890 model
Column: Agilent Technologies HP-5
Length: 30 m, inner diameter: 0.25 mm, film thickness: 0.25 μm
Oven: keeping at 50°C for 5 minutes - temperature rise at a rate of 10°C/min - keeping at 320°C for 10 minutes

<Amount of oxide of oligomer>

After films for deposition (A4 size x 2 films) were produced by forming, they were allowed to stand for 7 days under the conditions of 23°C and a relative humidity of 50%.

Subsequently, an operation of washing the non-deposition surface of each of the films for inorganic deposition with 10 mL of dichloromethane was repeated three times. Dichloromethane having been recovered after the washing was concentrated by an evaporator. Thereafter, from a peak intensity (m/z=420) of an ethylene decamer oligomer in the concentrate and a peak intensity (m/z=434) of an oxide of the ethylene decamer oligomer in the concentrate, both peaks being observed by FD-MS (apparatus, etc. are as follows), an intensity ratio A (peak intensity of oxide of ethylene decamer oligomer/peak intensity of ethylene decamer oligomer + peak intensity of oxide of ethylene decamer oligomer) was calculated. Further, ethylene oligomers (corresponding to hexamer to decamer) contained in the recovered dichloromethane were determined by gas chromatography in terms of a decamer as a standard substance, and the resulting value was taken as a total amount B (μg) of ethylene oligomers of hexamer to decamer.

Furthermore, a value of B (μg) x A (intensity ratio) was taken as an amount (μg) of an oxide of an oligomer.

FD-MS

Apparatus: JEOL MS JMS-T100GC model (time of flight mass spectrometer)

Agilent Technologies GC 6890 model
Varian Microscope FT-IR FTS-3100/UMA-600 model

<Wettability>

Immediately after production of inorganic substance deposited films, the inorganic substance deposited films were superposed one upon another in such a manner that the aluminum deposit surface and the non-deposition surface (sealing surface) were brought into close contact with each other, and a load of 10 kgf/100 cm$^2$ was applied to them in the laminating direction. Wetting index (unit: dyn/cm) of the deposit surface of each of the inorganic substance deposited films was measured immediately after production and after allowing the film to stand at 23°C for 7 days and 21 days in accordance with ASTM D523.

<Heat-sealing strength of inorganic substance deposited film immediately after production>

An inorganic substance deposited film given immediately after production by the above process (that is, immediately after deposition) and a biaxially oriented polypropylene film (non-antistatic grade, trade name: OP ME-1) one surface of which had been subjected to corona treatment and which had a thickness of 25 μm, said polypropylene film being commercially available from Mitsui Chemicals Tohcello, Inc., were subjected to dry lamination using a urethane-based adhesive of the following compounding in such a manner that the aluminum deposit surface of the inorganic substance deposited film and the corona treated surface of the polypropylene film were bonded to each other. Then, the resulting laminate was sandwiched between glass plates of flat surfaces, each glass plate having a length of 35 cm and a width of 13 cm, and allowed to stand for not shorter than 48 hours in a constant temperature air dryer at 40°C while a weight of 8 kg was placed on the laminate. Thus, laminate samples were obtained.

Urethane-based adhesive

(A) Product of Mitsui Chemicals, Inc. : trade name "Takelac A969"

(B) Product of Mitsui Chemicals, Inc.: trade name "Takenate A5"

Using ethyl acetate as a solvent, (A) and (B) were compounded in such a manner that (A):(B) became 18:6. Coating weight: 2.0 g/m$^2$

The laminate samples were taken out of the dryer, and the non-deposition surfaces on the inorganic substance deposited film sides were superposed one upon another, and heat-sealing strength of the laminate samples was measured in accordance with the following method.

A one-sided heat bar sealer was used.

Heat-sealing pressure: 2 kg/cm$^2$
Heat-sealing time: 1.0 second
Width of seal bar: 10 mm
Heat-sealing temperature: 140°C
Width of specimen: 15 mm
Peel angle: 180 degrees
Peel rate: 300 mm/min

<Heat-sealing strength of inorganic substance deposited film after storage of 40°C x 14 days>

From the inorganic substance deposited films produced by the above process, 20 inorganic substance deposited films were picked, and the 20 inorganic substance deposited films were superposed one upon another in such a manner that the deposit surface of one inorganic substance deposited film faced the non-deposition surface of another inorganic substance deposited film, then they were sandwiched between glass plates of flat surfaces, each glass plate having a length of 35 cm and a width of 13 cm, and allowed to stand for 14 days in a constant temperature air dryer at 40°C while a weight of 8 kg was placed on them. Thereafter, from the 20 inorganic substance deposited films, inorganic substance deposited films each having an aluminum deposit surface superposed on the non-deposition surface were selected, and each of the inorganic substance deposited films and a biaxially oriented polypropylene film (non-antistatic grade, trade name: OP ME-1) one surface of which had been subjected to corona treatment and which had a thickness of 25 μm, said polypropylene film being commercially available from Mitsui Chemicals Tohcello, Inc., were subjected to dry lamination using a urethane-based adhesive of the following compounding in such a manner that the aluminum deposit surface of the inorganic substance deposited film and the corona treated surface of the polypropylene film were bonded to each other. Then, each of the resulting laminates was sandwiched between glass plates of flat surfaces, each glass plate having a length of 35 cm and a width of 13 cm, and allowed to stand for not shorter than 48 hours in a constant temperature air dryer at 40 °C while a weight of 8 kg was placed on the laminate. Thus, laminate samples were obtained.

Urethane-based adhesive

(A) Product of Mitsui Chemicals, Inc. : trade name "Takelac A969"
(B) Product of Mitsui Chemicals, Inc.: trade name "Takenate A5"

Using ethyl acetate as a solvent, (A) and (B) were compounded in such a manner that (A):(B) became 18:6. Coating weight: 2.0 g/m$^2$

The laminate samples were taken out of the dryer, and the non-deposition surfaces of the inorganic substance deposited films were superposed one upon another, and heat-sealing strength of the laminate samples was measured in accordance with the following method.

A one-sided heat bar sealer was used.

Heat-sealing pressure: 2 kg/cm$^2$
Heat-sealing time: 1.0 second
Width of seal bar: 10 mm
Heat sealing temperature: 140°C
Width of specimen: 15 mm
Peel angle: 180 degrees
Peel rate: 300 mm/min

<Heat-sealing strength decrease ratio (%)>

In usual, the inorganic substance deposited film is used in many cases as a laminated film in which the deposit surface of the inorganic substance deposited film and a base material were dry laminated, and therefore, when the wetting index (wetting tension) of the deposit surface of the inorganic substance deposited film is lowered, the laminating strength between the deposit surface of the inorganic substance deposited film and the base material is decreased, and particularly, decrease in heat-sealing strength becomes conspicuous.

Then, the heat-sealing strength decrease ratio (%) represented by the following formula was calculated.

$$\text{Heat-sealing strength decrease ratio (\%)} = (S0-S14)/S0 \times 100$$

In the above formula, S0 is a heat-sealing strength of the inorganic substance deposited film (laminate sample) immediately after production, and S14 is a heat-sealing strength of the inorganic substance deposited film (laminate sample) after storage of 40°C x 14 days.

As the value of the heat-sealing strength decrease ratio increases, the decrease in heat-sealing strength is larger, and this indicates that the laminating strength is lowered, that is, decrease in wetting index (wetting tension) of the deposit surface is large.

<Deposition strength of inorganic substance deposit layer>

To the aluminum deposit layer surface of the inorganic substance deposited film, a Cellophane tape (NICHIBAN CT405AP-18) was stuck, then the Cellophane tape was peeled off at a rate of 300 mm/min, and using an autograph, deposition strength of the inorganic substance deposit layer, that is, peel strength between the inorganic substance deposit layer and the film for inorganic substance deposition, was measured. Meanings of the symbols in the table are as follows.

o : After peeling, the aluminum deposit layer was present on the side of the film for inorganic substance deposition.
x : After the peeling, the aluminum deposit layer was present on the side of the Cellophane tape.

The film with a symbol "x" has a problem in practical use.

[Example 1]

In a complete stirring-mixing type continuous polymerization reaction vessel having an internal volume of 1 L were introduced dry n-hexane at a rate of 4.3 1/hr, a hexane solution of a metallocene complex (di(p-tolyl)methylene(cyclopentadienyl)(octamethyloctahydrodiben zofluorenyl) zirconium dichloride) (0.16 mmol/L) at a rate of 0.0106 mmol/hr, a toluene solution of methylalumoxane (MMAO-3A, available from Tosoh Finechem Corporation) (80 mmol/L) at a rate of 5. 3 mmol/hr and a hexane solution of triisobutylaluminum (12 mmol/L) at a rate of 1.8 mmol/hr. Hydrogen was not introduced. At the same time, to the polymerization reaction vessel were continuously fed ethylene at a rate of 480 g/hr and 1-octene at a rate of 0.87 kg/hr, and polymerization reaction was carried out at a temperature of 150°C while the polymer solution was continuously drawn out from the upper part of the polymerization reaction vessel in such a manner that the pressure in the polymerization reaction vessel became 6.9 MPa. To the polymer solution continuously drawn out of the polymerization reaction vessel, a small amount of isopropyl alcohol was added as a deactivator, and by carrying out a flashing operation, the pressure in the polymerization reaction vessel was reduced to atmospheric pressure to precipitate a polymer. Thereafter, the polymer was dried by a vacuum dryer at 120°C over a period of 8 hours in a nitrogen stream. In this polymerization, the ethylene conversion was 92%, and the yield of the ethylene-based polymer was 0.62 kg/hr.

To the resulting polymer, 1000 ppm of Sumilizer GP (available from Sumitomo Chemical Co., Ltd.) was added, and thereafter, using a counter-rotation twin-screw extruder of 20 mmø manufactured by Toyo Seiki Seisaku-sho Ltd., they were melt-kneaded under the conditions of a preset temperature of 200°C and a screw rotation speed of 100 rpm and then extruded into strands. The strands were cut to obtain pellets (S-1) . The pellets (S-1) were formed into a film for inorganic substance deposition. Subsequently, on one surface of the film for inorganic substance deposition, deposition of aluminum was carried out to obtain an inorganic substance deposited film.

Properties of the ethylene-basedpolymer, the film for inorganic substance deposition and the inorganic substance deposited film were measured by the aforesaid methods. The evaluation results are set forth in Table 1.

[Example 2]

In a complete stirring-mixing type continuous polymerization reaction vessel having an internal volume of 1 L were introduced dry n-hexane at a rate of 4.3 1/hr, a hexane solution of a metallocene complex (di(p-tolyl)methylene(cyclopentadienyl)(octamethyloctahydrodiben zofluorenyl) zirconium dichloride) (0.16 mmol/L) at a rate of 0.0106 mmol/hr, a toluene solution of methylalumoxane (MMAO-3A, available from Tosoh Finechem Corporation) (80 mmol/L) at a rate of 5.3 mmol/hr and a hexane solution of triisobutylaluminum (12 mmol/L) at a rate of 1.8 mmol/hr. At the same time, to the polymerization reaction vessel were continuously fed ethylene at a rate of 480 g/hr, 1-octene at a rate of 0.87 kg/hr and hydrogen at a rate of 0.16 g/hr, and polymerization reaction was carried out at a temperature of 150°C while the polymer solution was continuously drawn out from the upper part of the polymerization reaction vessel in such a manner that the pressure in the polymerization reaction vessel became 6.9 MPa. To the polymer solution continuously drawn out of the polymerization reaction vessel, a small amount of isopropyl alcohol was added as a deactivator, and by carrying out a flashing operation, the pressure in the polymerization reaction vessel was reduced to atmospheric pressure to precipitate a polymer. Thereafter, the polymer was dried by a vacuum dryer at 120°C over a period of 8 hours in a nitrogen stream. In this polymerization, the ethylene conversion was 92%, and the yield of the ethylene-based polymer was 0.62 kg/hr.

To the resulting ethylene-based polymer, additives such as an antioxidant were not added. Theethylene-basedpolymerwaspelletized in the same manner as in Example 1, and the resulting pellets (S-2) were formed into a film for inorganic substance deposition. Subsequently, on one surface of the film for inorganic substance deposition, deposition of aluminum was carried out to obtain an inorganic substance deposited film.

Properties of the ethylene-basedpolymer, the film for inorganic substance deposition and the inorganic substance deposited film were measured by the aforesaid methods. The evaluation results are set forth in Table 1.

[Example 3]

In a complete stirring-mixing type continuous polymerization reaction vessel having an internal volume of 1 L were introduced dry n-hexane at a rate of 4.0 1/hr, a hexane solution of a metallocene complex (di(p-tolyl)methylene(cyclopentadienyl)(octamethyloctahydrodiben zofluorenyl) zirconium dichloride) (0.16 mmol/L) at a rate of 0.0072 mmol/hr, a toluene solution of methylalumoxane (MMAO-3A, available from Tosoh Finechem Corporation) (80 mmol/L) at a rate of 3.6 mmol/hr and a hexane solution of triisobutylaluminum (12 mmol/L) at a rate of 1.8 mmol/hr. At the same time, to the polymerization reaction vessel were continuously fed ethylene at a rate of 480 g/hr, 1-octene at a rate of 0.078 kg/hr and hydrogen at a rate of 0.30 g/hr, and polymerization reaction was carried out at a temperature of 150°C while the polymer solution was continuously drawn out from the upper part of the polymerization reaction vessel in such a manner that the pressure in the polymerization reaction vessel became 6.9 MPa. To the polymer solution continuously drawn out of the polymerization reaction vessel, a small amount of isopropyl alcohol was added as a deactivator, and by carrying out a flashing operation, the pressure in the polymerization reaction vessel was reduced to atmospheric pressure to precipitate a polymer. Thereafter, the polymer was dried by a vacuum dryer at 120°C over a period of 8 hours in a nitrogen stream. In this polymerization, the ethylene conversion was 93.5%, and the yield of the ethylene-based polymer was 0.45 kg/hr.

To the resulting ethylene-based polymer, additives such as an antioxidant were not added. The ethylene-based polymer was pelletized in the same manner as in Example 1, and the resulting pellets (S-3) were formed into a film for inorganic substance deposition. Subsequently, on one surface of the film for inorganic substance deposition, deposition of aluminum was carried out to obtain an inorganic substance deposited film.

Properties of the ethylene-basedpolymer, the film for inorganic substance deposition and the inorganic substance deposited film were measured by the aforesaid methods. The evaluation results are set forth in Table 1.

[Example 4]

Using pellets of an ethylene-based polymer (trade name: ULTZEX 4020M) obtained by solution polymerization, said polymer being commercially available from Prime Polymer Co., Ltd., a film for inorganic substance deposition was produced by forming. Subsequently, on one surface of the film for inorganic substance deposition, deposition of aluminum was carried out to obtain an inorganic substance deposited film.

Properties of the ethylene-basedpolymer, the film for inorganic substance deposition and the inorganic substance deposited film were measured by the aforesaid methods. The evaluation results are set forth in Table 1.

[Example 5]

In a complete stirring-mixing type continuous polymerization reaction vessel having an internal volume of 1 L were introduced dry n-hexane at a rate of 4.2 1/hr, a hexane solution of a metallocene complex (di(p-tolyl)methylene(cyclopentadienyl)(octamethyloctahydrodiben zofluorenyl) zirconium dichloride) (0.16 mmol/L) at a rate of 0.0106 mmol/hr, a toluene solution of methylalumoxane (MMAO-3A, available from Tosoh Finechem Corporation) (80 mmol/L) at a rate of 5.3 mmol/hr and a hexane solution of triisobutylaluminum (12 mmol/L) at a rate of 1.8 mmol/hr. Hydrogen was not introduced. At the same time, to the polymerization reaction vessel were continuously fed ethylene at a rate of 480 g/hr and 1-hexene at a rate of 0.65 kg/hr, and polymerization reaction was carried out at a temperature of 150°C while the polymer solution was continuously drawn out from the upper part of the polymerization reaction vessel in such a manner that the pressure in the polymerization reaction vessel became 6.9 MPa. To the polymer solution continuously drawn out of the polymerization reaction vessel, a small amount of isopropyl alcohol was added as a deactivator, and by carrying out a flashing operation, the pressure in the polymerization reaction vessel was reduced to atmospheric pressure to precipitate a polymer. Thereafter, the polymer was dried by a vacuum dryer at 120°C over a period of 8 hours in a nitrogen stream. In this polymerization, the ethylene conversion was 92%, and the yield of the ethylene-based polymer was 0.57 kg/hr.

To the resulting polymer, 1000 ppm of Irganox 1076 (trade name) was added, then they were pelletized in the same manner as in Example 1, and the resulting pellets (S-5) were formed into a film for inorganic substance deposition. Subsequently, on the deposition target surface of the film for inorganic substance deposition, deposition of aluminum was carried out to obtain an inorganic substance deposited film.

Properties of the ethylene-basedpolymer, the film for inorganic substance deposition and the inorganic substance deposited film were measured by the aforesaid methods. The evaluation results are set forth in Table 1.

[Table 1]

| | | | Ex. 1 | Ex. 2 | Ex. 3 | Ex. 4 | Ex. 5 |
|---|---|---|---|---|---|---|---|
| Remarks | | | Solution method metallocene | Solution method metallocene | Solution method metallocene | Solution method Ziegler | Solution method metallocene |
| Properties of ethylene-based polymer resin | Melt tension | g | 0.5 | 0.1 | 0.1 or less | 1.9 | 0.5 |
| | MFR | g/10min | 3.8 | 17 | 21 | 2.2 | 3.8 |
| | Density | kg/m$^3$ | 890 | 890 | 923 | 937 | 890 |
| | Mw/Mn | - | 2.0 | 2.0 | 2.0 | 2.6 | 2.0 |
| Properties of resin film for deposition | Oxidized oligomer | μg/A4×2 films | 1.0 or less | 1.0 or less | 1.0 or less | 1.0 or less | 1.0 or less |
| | Low-molecular weight component | ng/mg | 730 | 260 | 300 | 140 | 700 |
| | Pentavalent phosphorus compound | μg/A4×2 films | 8 | 0 | 0 | 0 | 6 |
| Properties of deposited film | Wettability (before rolled up) | dyn | 60 | 60 | 60 | 60 | 60 |
| | Wettability (immediately after) | dyn | 60 | 60 | 60 | 60 | 60 |
| | Wettability (after 7 days) | dyn | 40 | 40 | 60 | 50 | 42 |
| | Wettability (after 21 days) | dyn | 40 | 40 | 60 | 50 | 42 |
| | Heat-sealing strength (immediately after) | N/15mm | 25 | 25 | 30 | 28 | 23 |
| | Heat-sealing strength decrease ratio | % | 15 | 8 | 8 | 13 | 15 |
| | Deposition strength | - | ○ | ○ | ○ | ○ | ○ |

[Comparative Example 1]

An ethylene-based polymer was produced in accordance with the process described in Production Example 1 A-2 of Japanese Patent Laid-Open Publication No. 1997-183816. To the resulting polymer, 1000 ppm of Sumilizer GP (available from Sumitomo Chemical Co., Ltd.) was added, then they were pelletized in the same manner as in Example 1, and the resulting pellets (C-1) were formed into a film for inorganic substance deposition. Subsequently, on one surface of the film for inorganic substance deposition, deposition of aluminum was carried out to obtain an inorganic substance deposited film.

Properties of the ethylene-basedpolymer, the film for inorganic substance deposition and the inorganic substance deposited film were measured by the aforesaid methods. The evaluation results are set forth in Table 2.

[Comparative Example 2]

An ethylene-based polymer was produced in accordance with the process described in Production Example 1 A-4 of Japanese Patent Laid-Open Publication No. 1997-183816, and without adding an antioxidant, the ethylene-based polymer was pelletized in the same manner as in Example 1. The resulting pellets (C-2) were formed into a film for inorganic substance deposition. Subsequently, on one surface of the film for inorganic substance deposition, deposition of aluminum was carried out to obtain an inorganic substance deposited film.

Properties of the ethylene-basedpolymer, the film for inorganic substance deposition and the inorganic substance deposited film were measured by the aforesaid methods. The evaluation results are set forth in Table 2.

[Comparative Example 3]

Pellets of an ethylene/4-methyl-1-pentene copolymer (trade name: ULTZEX 4020L) produced by solution polymerization, said copolymer being commercially available from Prime Polymer Co., Ltd. , were formed into a film for inorganic substance deposition. Subsequently, on one surface of the film for inorganic substance deposition, deposition of aluminum was carried out to obtain an inorganic substance deposited film.

Properties of the ethylene-basedpolymer, the film for inorganic substance deposition and the inorganic substance deposited film were measured by the aforesaid methods. The evaluation results are set forth in Table 2.

[Comparative Example 4]

Pellets of polyethylene (trade name: Mirason 11) produced by high-pressure radical polymerization, said polyethylene being commercially available from DuPont-Mitsui Polychemicals Co., Ltd., were formed into a film for inorganic substance deposition. Subsequently, on one surface of the film for inorganic substance deposition, deposition of aluminum was carried out to obtain an inorganic substance deposited film.

Properties of the ethylene-basedpolymer, the film for inorganic substance deposition and the inorganic substance deposited film were measured by the aforesaid methods. The evaluation results are set forth in Table 2.

[Table 2]

| | | | Comp. Ex. 1 | Comp Ex 2 | Comp. Ex. 3 | Comp. Ex. 4 |
|---|---|---|---|---|---|---|
| Remarks | | | Vapor phase method metallocene | Vapor phase method metallocene | Solution method Ziegler | High-pressure-processed LDPE |
| Properties of ethylene-based polymer resin | Melt tension | g | 0.6 | 0.6 | 1.9 | 6.8 |
| | MFR | g/10min | 4.0 | 4.3 | 2.2 | 7.0 |
| | Density | $kg/m^3$ | 921 | 904 | 937 | 918 |
| | Mw/Mn | - | 2.2 | 3.1 | 2.6 | 9.5 |

(continued)

| | | | Comp. Ex. 1 | Comp Ex 2 | Comp. Ex. 3 | Comp. Ex. 4 |
|---|---|---|---|---|---|---|
| Properties of resin film for deposition | Oxidized oligomer | μg/A4×2 films | 1.7 | 6.6 | 1.0 or less | 1.0 or less |
| | Low-molecular weight component | ng/mg | 790 | 1300 | 730 | 440 |
| | Pentavalent phosphorus compound | μg/A4×2 films | 10 | 0 | 10 | 0 |
| Properties of deposited film | Wettability (before rolled up) | dyn | 60 | 60 | 60 | 60 |
| | Wettability (immediately after) | dyn | 60 | 60 | 60 | 60 |
| | Wettability (after 7 days) | dyn | 30 or less | 30 or less | 30 or less | 38 |
| | Wettability (after 21 days) | dyn | 30 or less | 30 or less | 30 or less | 38 |
| | Heat-sealing strength (immediately after) | N/15mm | 30 | 28 | 38 | 15 |
| | Heat-sealing strength decrease ratio | % | 40 | 45 | 40 | 10 |
| | Deposition strength | - | ○ | ○ | ○ | ○ |

[Example 6]

The pellets (S-3) of the ethylene-based polymer used in Example 3 were used for a deposition target layer and an intermediate layer, and the pellets (S-1) of the ethylene-based polymer used in Example 1 were used for a non-deposition layer, whereby a 3-layer film was prepared. On the deposition target layer of the resulting film for inorganic substance deposition constituted of three layers, deposition of aluminum was carried out.
The evaluation results are set forth in Table 3.

[Example 7]

Thepellets (4020M) of the ethylene-based polymer used in Example 4 were used for a deposition target layer and an intermediate layer, and the pellets (S-3) of the ethylene-based polymer used in Example 3 were used for a non-deposition layer, whereby a 3-layer film was prepared. On the deposition target layer of the resulting film for inorganic substance deposition constituted of three layers, deposition of aluminum was carried out.
The evaluation results are set forth in Table 3.

[Example 8]

Thepellets (4020M) oftheethylene-basedpolymerusedinExample 4 were used for a deposition target layer and an intermediate layer, and the pellets (S-2) of the ethylene-based polymer used in Example 2 were used for a non-deposition layer, whereby a 3-layer film was prepared. On the deposition target layer of the resulting film for inorganic substance deposition constituted of three layers, deposition of aluminum was carried out.

The evaluation results are set forth in Table 3.

[Comparative Example 5]

Thepellets (4020M) oftheethylene-basedpolymerusedinExample 4 were used for a deposition target layer and an intermediate layer, and the ethylene copolymer pellets (C-1) used in Comparative Example 1 were used for a non-deposition layer, whereby a 3-layer film was prepared. On the deposition target layer of the resulting film for inorganic substance deposition constituted of three layers, deposition of aluminum was carried out.

The evaluation results are set forth in Table 3.

[Comparative Example 6]

The pellets (4020L) of the ethylene polymer used in Comparative Example 3 were used for a deposition target layer and an intermediate layer, and the pellets (S-3) of the ethylene-based polymer used in Example 3 were used for a non-deposition layer, whereby a 3-layer film was prepared. On the deposition target layer of the resulting film for inorganic substance deposition constituted of three layers, deposition of aluminum was carried out.

The evaluation results are set forth in Table 3.

[Table 3]

| | | | Ex. 6 | Ex. 7 | Ex. 8 | Comp. Ex. 5 | Comp. Ex. 6 |
|---|---|---|---|---|---|---|---|
| Constitution of film for deposition (3-layer film) | Laminate layer | | S-3 | 4020M | 4020M | 4020M | 4020L |
| | Intermediate layer | | S-3 | 4020M | 4020M | 4020M | 4020L |
| | Sealing layer | | S-1 | S-3 | S-2 | C-1 | S-3 |
| Properties of resin film for deposition | Oxidized oligomer | $\mu$g/A4$\times$2 films | 1.0 or less | 1.0 or less | 1.0 or less | 1.7 | 1.0 or less |
| | Low-molecular weight component | ng/mg | 730 | 260 | 300 | 300 | 700 |
| | Pentavalent phosphorus compound | $\mu$g/A4$\times$2 films | 8 | 0 | 0 | 10 | 10 |
| Properties of deposited film | Wettability (before rolled up) | dyn | 60 | 60 | 60 | 60 | 60 |
| | Wettability (immediately after) | dyn | 60 | 60 | 60 | 60 | 60 |
| | Wettability (after 7 days) | dyn | 50 | 60 | 50 | 30 or less | 30 or less |
| | Wettability (after 21 days) | dyn | 50 | 60 | 50 | 30 or less | 30 or less |
| | Heat-sealing strength (immediately after) | N/15mm | 25 | 30 | 28 | 30 | 25 |
| | Heat-sealing strength decrease ratio | % | 10 | 8 | 8 | 40 | 38 |
| | Deposition strength | - | ○ | ○ | ○ | ○ | ○ |

In the inorganic substance deposited films of Examples 1 and 5, polyethylene produced by a solution method using a metallocene catalyst was used as the ethylene-based polymer (A) . The composition distribution and the molecular weight distribution of this polyethylene were narrow, and the amount of a volatile component in the polyethylene was also small. As the antioxidant, Sumilizer GP was added. The wetting indexes of the aluminum deposit layers immediately after production of the films for inorganic substance deposition were each 60 dyn. The wetting indexes of the aluminum deposited layers after the inorganic substance deposited films were superposed and allowed to stand for 7 days were 40 dyn and 42 dyn. Even though a given period of time had passed after production of the inorganic substance deposited films, bleed-out of an oxide of the antioxidant was not detected, and decrease in wettability of the aluminum deposit layers was small.

In the inorganic substance deposited films of Examples 2 and 3, polyethylene produced by a solution method using a metallocene catalyst was used as the ethylene-based polymer (A). The composition distribution and the molecular weight distribution of this polyethylene were narrow, and the amount of a volatile component in the polyethylene was also small. In these films, an antioxidant was not added, so that even though a given period of time had passed after production of the inorganic substance deposited films, bleed-out of an oxide of the antioxidant was not detected, and decrease in wettability of the aluminum deposit layers was small.

In the inorganic substance deposited film of Example 4, polyethylene produced by a solution method using a Ziegler catalyst was used as the ethylene-based polymer (A). Polymerization was carried out in such a manner that the molecular weight distribution and the composition distribution became narrow, and an antioxidant was not added, so that even though a given period of time had passed after production of the inorganic substance deposited film, decrease in wettability of the aluminum deposit layer was small.

In the inorganic substance deposited film of Comparative Example 1, polyethylene produced by a vapor phase method using a metallocene catalyst was used as the ethylene-based polymer (A). The molecular weight distribution of this polyethylene was relatively narrow, and the amount of a volatile component in the polyethylene was also small, but when a given period of time had passed after production of the inorganic substance deposited film, bleed-out of an oxide of the antioxidant was detected, and wettability of the aluminum deposit layer of the deposited film was largely decreased.

In the inorganic substance deposited film of Comparative Example 2, polyethylene produced by a vapor phase method using a metallocene catalyst was used as the ethylene-based polymer (A). The molecular weight distribution of this polyethylene was relatively wide, and the amount of a volatile component in the polyethylene was large, so that when a given period of time had passed after production of the inorganic substance deposited film, wettability of the deposit layer surface was largely decreased though an antioxidant was not added.

In the inorganic substance deposited film of Comparative Example 3, polyethylene produced by a solution method using a Ziegler catalyst was used as the ethylene-based polymer (A). The molecular weight distribution of this polyethylene was relatively narrow, and the amount of a volatile component in the polyethylene was also small, but when a given period of time had passed after production of the inorganic substance deposited film, bleed-out of an oxide of the phosphorus-based antioxidant was detected, and wettability of the aluminum deposit layer was largely decreased.

In the inorganic substance deposited film of Comparative Example 4, high-pressure-processed LDPE was used as the ethylene-based polymer. The melt tension of this polyethylene, as measured at 190 °C, was larger than 5.0 g, and therefore, the strength of the film was poor.

In the inorganic substance deposited films of Examples 6 to 8, a raw material, which had a narrow molecular weight distribution and a narrow composition distribution and in which a component causing bleed-out was not detected when a single layer film was prepared, was used in all of the three layers of each film, and therefore, even though a given period of time had passed after production of the inorganic substance deposited films, decrease in wettability of the aluminum deposit layers was small.

In the inorganic substance deposited films of Comparative Examples 5 and 6, a raw material, in which a component causing bleed-out was detected when a single layer film was prepared, was used in any one of the three layers of each film, and therefore, when a given period of time had passed after production of the inorganic substance deposited films, wettability of the aluminum deposit layers was largely decreased.

Industrial Applicability

The inorganic substance deposited film obtained by depositing an inorganic substance on one surface of the film for inorganic substance deposition of the present invention and the laminated film obtained by laminating the inorganic substance deposited film with a base material are preferable as films usually referred to as packaging materials, for example, those for refrigerated or frozen vegetables and all processed foods, all of foods, such as snacks (snack, chocolate, candy, pie, etc.), beverages (sake, shochu, wine, juice, milk, etc.) and seasonings (soy sauce, sweet sake for seasoning, dressing, etc.), medicines, industrial materials, daily miscellaneous goods, and chemicals (detergent, oil, paint, etc.). Further, they can be applied not only to packaging materials but also to uses to which they are applied for the reason of design characteristics of the deposit surface.

**Claims**

1. A film for inorganic substance deposition, comprising single or multiple resin layers, wherein all of the resin layers contain an ethylene-based polymer (A) having a melt tension (MT), as measured at 190 °C, of not more than 5.0 g, and the film satisfies the following requirements (1) to (3),

   requirement (1) : the amount of a component generated by allowing the film for inorganic substance deposition to stand for not shorter than 7 days under the conditions of 23 °C and a relative humidity of 50%, then heating the film at 300 °C for 5 minutes in a helium stream, trapping a generated gas at -100 °C and then further carrying out heating at 300 °C for 2 minutes is not more than 1.2 $\mu$g per milligram of the film for inorganic substance deposition,
   requirement (2) : the amount of a compound containing pentavalent phosphorus, said compound being contained in dichloromethane having been used for washing a surface of the film for inorganic substance deposition by the following method and recovered after the washing, is not more than 9 $\mu$g, and
   requirement (3): the amount of an oxide of an oligomer of a hexamer to a decamer, said oxide being contained in dichloromethane having been used for washing a surface of the film for inorganic substance deposition by the following method and recovered after the washing, is not more than 1.5 $\mu$g,
   (washing method with dichloromethane): a surface of each of two sheets of the film for inorganic substance deposition of A4 size having been allowed to stand for not shorter than 7 days under the conditions of 23 °C and a relative humidity of 50% and then inclined at 45° to a horizontal plane, said surface being on the opposite side to the surface where an inorganic substance deposit layer is to be formed, is repeatedly subjected to an operation of washing with 10 mL of dichloromethane three times to wash the surface.

2. The film for inorganic substance deposition as claimed in claim 1, wherein the melt tension (MT) of the ethylene-based polymer (A), as measured at 190 °C, is not less than 0.1 g but not more than 5.0 g, and the requirements (1) to (3) are as follows:

   requirement (1) : the amount of a component generated by allowing the film for inorganic substance deposition to stand for not shorter than 7 days under the conditions of 23 °C and a relative humidity of 50%, then heating the film at 300 °C for 5 minutes in a helium stream, trapping a generated gas at -100 °C and then further carrying out heating at 300 °C for 2 minutes is not less than $1.0 \times 10^{-6}$ $\mu$g but not more than 1.2 $\mu$g per milligram of the film for inorganic substance deposition,
   requirement (2) : the amount of a compound containing pentavalent phosphorus, said compound being contained in dichloromethane having been used for washing a surface of the film for inorganic substance deposition by the following method and recovered after the washing, is not less than $1.0 \times 10^{-6}$ $\mu$g but not more than 9 $\mu$g, and
   requirement (3): the amount of an oxide of an oligomer of a hexamer to a decamer, said oxide being contained in dichloromethane having been used for washing a surface of the film for inorganic substance deposition by the following method and recovered after the washing, is not less than $1.0 \times 10^{-6}$ $\mu$g but not more than 1.5 $\mu$g,
   (washing method with dichloromethane): a surface of each of two sheets of the film for inorganic substance deposition of A4 size having been allowed to stand for not shorter than 7 days under the conditions of 23 °C and a relative humidity of 50% and then inclined at 45° to a horizontal plane, said surface being on the opposite side to the surface where an inorganic substance deposit layer is to be formed, is repeatedly subjected to an operation of washing with 10 mL of dichloromethane three times to wash the surface.

3. The film for inorganic substance deposition as claimed in claim 1 or 2, wherein the ethylene-based polymer (A) is an ethylene-based copolymer obtained by copolymerizing ethylene and an $\alpha$-olefin of 4 to 10 carbon atoms and satisfying the following requirements (I) and (II) at the same time,

   requirement (I): the melt flow rate (MFR), as measured under the conditions of 190 °C and a load of 2.16 kg in accordance with ASTM D1238-89, is in the range of 0.1 to 30 g/10 min, and
   requirement (II): the density (D) is in the range of 870 to 970 kg/m$^3$.

4. An inorganic substance deposited film comprising an inorganic substance deposit layer composed of an inorganic substance on one surface of the film for deposition as claimed in any one of claims 1 to 3.

5. The inorganic substance deposited film as claimed in claim 4, wherein the inorganic substance is at least one kind selected from aluminum, silicon oxide, aluminum oxide, indium oxide and tin oxide.

6. A production process for an inorganic substance deposited film, being a production process for the inorganic substance deposited film as claimed in claim 4 and comprising:

a step A of subjecting at least one surface of the film for inorganic substance deposition to one or more treatments selected from a corona treatment, a flame treatment, a plasma treatment and an UV treatment, and
a step B of forming, after the step A, the inorganic substance deposit layer on the surface having been subjected to the treatment, by at least one method selected from a vacuum deposition method, a sputtering method and an ion plating method.

7. A laminated film comprising the inorganic substance deposited film as claimed in claim 4 or 5 and a base material layer provided on a surface of the inorganic substance deposit layer, said surface being on the opposite side to the film for inorganic substance deposition.

8. The laminated film as claimed in claim 7, wherein the base material layer has been laminated on the inorganic substance deposit layer by using a dry lamination method.

9. A packaging body using the inorganic substance deposited film as claimed in claim 4 or 5 or the laminated film as claimed in claim 7 or 8.

10. A f i lm roll obtained by winding the inorganic substance deposited film as claimed in claim 4 or 5 into a roll.

11. A production process for a film for inorganic substance deposition, comprising a step of forming a resin into single or multiple resin layers, said resin containing an ethylene-based polymer (A) having a melt tension (MT), as measured at 190°C, of not more than 5.0 g and satisfying the following requirements (1) to (3) when the resin is formed into a resin layer,

requirement (1) : the amount of a component generated by allowing the resin layer to stand for not shorter than 7 days under the conditions of 23 °C and a relative humidity of 50%, then heating the resin layer at 300 °C for 5 minutes in a helium stream, trapping a generated gas at -100°C and then further carrying out heating at 300°C for 2 minutes is not more than 1.2 $\mu$g per milligram of the resin layer,
requirement (2) : the amount of a compound containing pentavalent phosphorus, said compound being contained in dichloromethane having been used for washing a surface of the resin layer by the following method and recovered after the washing, is not more than 9 $\mu$g, and
requirement (3): the amount of an oxide of an oligomer of a hexamer to a decamer, said oxide being contained in dichloromethane having been used for washing a surface of the resin layer by the following method and recovered after the washing, is not more than 1.5 $\mu$g,
(washing method with dichloromethane): a surface of each of two sheets of the resin layer of A4 size having been allowed to stand for not shorter than 7 days under the conditions of 23 °C and a relative humidity of 50% and then inclined at 45° to a horizontal plane is repeatedly subjected to an operation of washing with 10 mL of dichloromethane three times to wash the surface.

12. The production process for a film for inorganic substance deposition as claimed in claim 11, wherein the melt tension (MT) of the ethylene-based polymer (A), as measured at 190°C, is not less than 0.1 g but not more than 5.0 g, and the requirements (1) to (3) are as follows:

requirement (1) : the amount of a component generated by allowing the resin layer to stand for not shorter than 7 days under the conditions of 23 °C and a relative humidity of 50%, then heating the resin layer at 300 °C for 5 minutes in a helium stream, trapping a generated gas at -100 °C and then further carrying out heating at 300 °C for 2 minutes is not less than $1.0 \times 10^{-6}$ $\mu$g but not more than 1.2 $\mu$g per milligram of the resin layer,
requirement (2) : the amount of a compound containing pentavalent phosphorus, said compound being contained in dichloromethane having been used for washing a surface of the resin layer by the following method and recovered after the washing, is not less than $1.0 \times 10^{-6}$ $\mu$g but not more than 9 $\mu$g, and
requirement (3): the amount of an oxide of an oligomer of a hexamer to a decamer, said oxide being contained in dichloromethane having been used for washing a surface of the resin layer by the following method and recovered after the washing, is not less than $1.0 \times 10^{-6}$ $\mu$g but not more than 1.5 $\mu$g,
(washing method with dichloromethane): a surface of each of two sheets of the resin layer of A4 size having been allowed to stand for not shorter than 7 days under the conditions of 23 °C and a relative humidity of 50% and then inclined at 45° to a horizontal plane is repeatedly subjected to an operation of washing with 10 mL of dichloromethane three times to wash the surface.

## INTERNATIONAL SEARCH REPORT

International application No.

PCT/JP2015/078260

### A. CLASSIFICATION OF SUBJECT MATTER
$B32B27/32(2006.01)i$, $C08F210/16(2006.01)i$, $C08J5/18(2006.01)i$, $B65D65/40(2006.01)n$

According to International Patent Classification (IPC) or to both national classification and IPC

### B. FIELDS SEARCHED

Minimum documentation searched (classification system followed by classification symbols)
C08F6/00-246/00, C08F301/00, C08J5/00-5/02, C08J5/12-5/22, B32B1/00-43/00, C23C14/00-14/58

| Documentation searched other than minimum documentation to the extent that such documents are included in the fields searched | | | |
|---|---|---|---|
| Jitsuyo Shinan Koho | 1922–1996 | Jitsuyo Shinan Toroku Koho | 1996–2015 |
| Kokai Jitsuyo Shinan Koho | 1971–2015 | Toroku Jitsuyo Shinan Koho | 1994–2015 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X<br>Y | JP 2012-136666 A (Tosoh Corp.),<br>19 July 2012 (19.07.2012),<br>claims 1, 2, 5; paragraphs [0020], [0040];<br>examples<br>(Family: none) | 4,5,7-9<br>1-12 |
| Y | JP 06-270357 A (Kohjin Co., Ltd.),<br>27 September 1994 (27.09.1994),<br>claims 1 to 3; paragraphs [0003], [0007],<br>[0009]; examples<br>(Family: none) | 1-12 |
| Y | JP 07-047638 A (Tosoh Corp.),<br>21 February 1995 (21.02.1995),<br>claims 1, 2; paragraphs [0001] to [0004],<br>[0017], [0025]; examples<br>(Family: none) | 1-12 |

☒ Further documents are listed in the continuation of Box C.       ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>    18 December 2015 (18.12.15) | Date of mailing of the international search report<br>    28 December 2015 (28.12.15) |
|---|---|
| Name and mailing address of the ISA/<br>    Japan Patent Office<br>    3-4-3,Kasumigaseki,Chiyoda-ku,<br>    Tokyo 100-8915,Japan | Authorized officer<br><br>Telephone No. |

Form PCT/ISA/210 (second sheet) (July 2009)

**INTERNATIONAL SEARCH REPORT**

International application No.

PCT/JP2015/078260

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 07-041571 A  (Tosoh Corp.),<br>10 February 1995 (10.02.1995),<br>claims 1, 2; paragraphs [0001] to [0005],<br>[0015], [0024]; examples<br>(Family: none) | 1-12 |
| Y | JP 09-277442 A  (Mitsui Petrochemical<br>Industries, Ltd.),<br>28 October 1997 (28.10.1997),<br>claims 2 to 4; paragraphs [0004], [0030]<br>(Family: none) | 1-12 |
| Y | JP 2004-175884 A  (Japan Polypropylene Corp.),<br>24 June 2004 (24.06.2004),<br>claims 1 to 5; paragraph [0038]<br>(Family: none) | 1-12 |
| Y | JP 09-156024 A  (Toppan Printing Co., Ltd.),<br>17 June 1997 (17.06.1997),<br>claim 1; paragraphs [0004], [0013]<br>(Family: none) | 1-12 |
| Y | WO 2007/094378 A1  (Mitsui Chemicals, Inc.),<br>23 August 2007 (23.08.2007),<br>claims 1 to 6; paragraphs [0005], [0042] to<br>[0045]; examples<br>& US 2009/0018299 A1<br>claims 1 to 6; paragraphs [0005], [0055] to<br>[0063]; examples<br>& EP 1990352 A1        & KR 10-2008-0102190 A<br>& CN 101384628 A | 1-12 |
| Y | WO 2013/118504 A1  (Mitsui Chemicals Tohcello,<br>Inc.),<br>15 August 2013 (15.08.2013),<br>claims 1, 5, 8; paragraphs [0061], [0074];<br>examples<br>& US 2015/0013755 A1<br>claims 1, 5, 8; paragraphs [0101], [0118];<br>examples<br>& CN 104105773 A        & KR 10-2014-0117489 A<br>& TW 201339227 A | 1-12 |
| A | JP 2012-227453 A  (Mitsui Chemicals, Inc.),<br>15 November 2012 (15.11.2012),<br>entire text<br>(Family: none) | 1-12 |
| A | JP 2013-022909 A  (Mitsui Chemicals Tohcello,<br>Inc.),<br>04 February 2013 (04.02.2013),<br>entire text<br>(Family: none) | 1-12 |

Form PCT/ISA/210 (continuation of second sheet) (July 2009)

**INTERNATIONAL SEARCH REPORT**

| International application No. |
| --- |
| PCT/JP2015/078260 |

C (Continuation).　DOCUMENTS CONSIDERED TO BE RELEVANT

| Category* | Citation of document, with indication, where appropriate, of the relevant passages | Relevant to claim No. |
| --- | --- | --- |
| A | JP 2007-175987 A (Showa Highpolymer Co., Ltd.), 12 July 2007 (12.07.2007), entire text (Family: none) | 1-12 |
| A | JP 02-240118 A (Mitsubishi Kasei Corp.), 25 September 1990 (25.09.1990), entire text (Family: none) | 1-12 |

Form PCT/ISA/210 (continuation of second sheet) (July 2009)

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 7166328 A
- JP 58019309 A
- JP 9193324 A
- JP 4346004 B
- JP 9183816 A

**Non-patent literature cited in the description**

- **KAZUO SOGA et al.** Catalytic Olefin Polymerization. Kodansha scientific, 1990, 376
- **WALTER KAMINSKY.** *Makromol. Chem.,* 1992, vol. 193, 606
- **Z. CRUBISIC ; P. REMPP ; H. HENOIT.** *J. Polym. Sci.,* 1967, vol. B5, 753